# EUROPEAN PATENT SPECIFICATION

(11) **EP 2 035 603 B1**
(45) Date of publication and mention of the grant of the patent: **18.01.2017**
(21) Application number: 07786894.1
(22) Date of filing: 28.06.2007
(51) Int. Cl.: C30B 7/00, B82Y 30/00, C30B 29/16, C30B 29/62, C01G 9/02

(54) **METHOD FOR THE MANUFACTURING OF A NANOROD**
VERFAHREN ZUR HERSTELLUNG EINES NANOSTABS
PROCÉDÉ DE FABRICATION D'UNE NANOTIGE

(30) Priority: 30.06.2006 EP 06116370
(43) Date of publication of application: 18.03.2009
(73) Proprietor: LightLab Sweden AB, 754 50 Uppsala (SE)
(72) Inventor: WILLANDER, Magnus, 582 28 Linköping (SE); HU, Quihong, 413 14 Göteborg (SE)
(74) Representative: Kransell & Wennborg KB
(86) International application number: PCT/EP2007/056502
(87) International publication number: WO 2008/000802

(56) References cited:
- WO-A-2004/114422
- US-A1- 2005 009 224
- Y. W. HEO; D. P. NORTON; L. C. TIEN; Y. KWON; B. S. KANG; F. REN; S. J. PEARTON; J. R. LAROCHE: "ZnO nanowire growth and devices" MATERIALS SCIENCE AND ENGINEERING R, vol. 47, 25 December 2004 (2004-12-25), pages 1-47, XP002404221
- SZ-CHIAN LIOU; CHI-SHENG HSIAO; SAN-YUAN CHEN: "Growth behavior and microstructure evolution of ZnO nanorods grown on Si in aqueous solution" JOURNAL OF CRYSTAL GROWTH, vol. 274, 18 November 2004 (2004-11-18), pages 438-446, XP002404222
- KÖNENKAMP R ET AL: "Vertical nanowire light-emitting diode" APPLIED PHYSICS LETTERS, AIP, AMERICAN INSTITUTE OF PHYSICS, MELVILLE, NY, US, vol. 85, no. 24, 13 December 2004 (2004-12-13), pages 6004-6006, XP012063838 ISSN: 0003-6951

## Description

### Field of the invention

The present invention relates to a method for the manufacturing of a nanorod.

### Description of the related art

ZnO with the band gap of 3.37 eV at room temperature and the exciton binding energy of 60 meV, rich variety of nanostructures, and inexpensiveness have attracted a great attention as a potential commercially viable candidate for ultraviolet light emitters ushering applications in laser diodes, high brightness light emitting diodes in ultraviolet and visible ranges. The demonstration of optical lasing at room temperature from ZnO nanowires unveiled the great potential in fabricating very high efficiency light emitters, and escalated the research on finding and utilizing cost effective and up-scalable production methods for the growth of ZnO nanowires.

Apart from physical methods such as molecular beam epitaxi, pulsed laser ablation, various chemical methods have also been developed, among others, the catalytic vapour-liquid-solid growth, which allows the growth of the nanowires at temperatures between 800 and 900 degrees Celsius, thermal decomposition of Zn3N2 or of ZnCl2 and oxidation between 300 and 600 degrees Celsius. The ZnO nanowires have been grown on various kinds of substrates, Si, SiC, GaAs, and Sapphire. Today nanowires are thus grown in high temperature which is both laborious and expensive, e.g. since there is a risk of contaminating of the nanowire, e.g. during the heating by diffusion.

A particularly interesting development is the so-called low temperature growth, where the growth takes place at about 95 degrees Celsius in aqueous solution. This method involves two processes, a homogeneous or heterogeneous nucleation of ZnO, and a subsequent growth of the nanowires. The sites for homogeneous nucleation, or the seed layer, are created by depositing Zn-containing precursors on a substrate and oxidizing it. The quality of the nucleation sites in terms of density, uniformity and the strength of adhesion to the substrate rely heavily on the completeness of the oxidation. Depending on the precursors chosen and its thickness, the temperature required for the oxidation can be as high as 420 degrees Celsius (X. Feng et al., J. Am. Chem. Soc. 2004, 126, 63 (2004). Such a high temperature excludes the possibility of growing ZnO nanowires on substrates like plastics, or other temperature sensitive materials.

An example of a method for growing nanowires on various substrates under mild aqueous conditions in a low temperature interval is disclosed in US 2005/0009224. However, the disclosed growth method is complex, and thus results in an expensive end product.

### Object of the invention

It is of great societal value, perhaps especially in the information display and lighting industry, to be able manufacture nanorods at low temperature on different kinds of substrates, including inexpensive substrates such as plastic, glass, silicon, etc, and to be able to offer nanorods presenting intact structural and physical properties. There is therefore a need for a novel method for the manufacturing of a nanorod, and more specifically that handles the prior art problems with slow growth in a low temperature interval.

### Summary of the invention

According to an aspect of the invention, the above object is met by a method for the manufacturing of a nanorod, comprising the steps of providing a substrate, forming an essentially flat electrically conductive layer on a surface of the substrate, the conductive layer having a thickness in the range of more than 0.5 to 3 nm, thereby forming an assembly, preparing a mixture comprising a Zinc containing precursor and tetramine in water, adding a salt comprising at least one of Mg2+ and Cd2+ to the mixture, heat treating the assembly in the mixture in a temperature interval between 30 and 120 degrees Celsius, and drying the assembly.

The present invention is based on the today commonly used thin film light emitting diode (LED) technology based on GaN, including heterostructures and quantum wells. Alloys of InGaN are grown periodically in order to confine electrons and holes to a certain region, improving internal efficiency, as holes and electrons are confined to a region due to the differences in electric potential, which makes then eventually recombine. Just as if a ball would fall into a well, an electron gets trapped into a well due to differences in electric potential and has difficulty to escape from the well.

Typically a modern High Brightness LED design includes a multi-quantum well (MQW) region sandwiched between n- and p- layers. Electrons and holes are injected into the active region and get trapped inside the wells and recombine, leading to emission of light.

A more simplified design is a so-called double heterostructures. This involves one longer "well" in the middle of two barriers. Similar advantages as in GaN case are obtained in the case of ZnO, when carriers are confined. The heterostructures are grown with the help of Mg, Cd, and Mn, and allows creating MgZnO, CdZnO and MnZnO alloys. MgZnO and MnZnO have a large band gap than ZnO, while CdZnO has a smaller band gap. The band gap varies linearly depending on the proportion of Mg, Cd and Mn that is contained in the alloy, typically a few % to 10% is contained, while about the maximum that is soluble is about 33%.

MgZnO and CdZnO alloys have been grown in ZnO thin films and nanowires, however they have been realized with high temperature growth methods such as MOCVD. What is unique in low temperature growth method is that it can be realized in a solution in the interval between 30 and 120 degrees Celsius. Realizing this in a solution at this temperature bears a number of advantages, where the main of course is a cost reduction. In comparison, high temperature growth of quantum wells and double heterostructures requires high precision and is thus costly as the growth rate is extremely slow, which makes the throughput low.

Another advantage with the present invention includes the creation of sharper junctions between different materials. As the process runs at a temperature interval between 30 and 120 degrees Celsius, the diffusion is practically inexistent, which is not the case with high temperature processes. Also, the crystal grown by low temperature growth usually emits white light instead of UV-light, which is advantageous in numerous applications (for example, no phosphors are required).

Further advantages with the invention includes an ease to deposit a seed layer, deposition of very thin seed (nucleation) layer, such as <0,5nm, thus the seed (nucleation layer) will not impact the recombination zone and thus emission properties. Such is the case in deposition of nanocrystals. The seed layer can be deposited uniformly using e.g. e-beam evaporation and/or using photolithography for instance, allowing for the deposit of single wires to have single emitters as well as to deposit nucleation spots (such as 200 nanometers in diameter). This will further allow for the control of the diameter of the wires themselves as well as the placing of the wires. Furthermore, having placed wires in controlled spots, enables to further control the deposition of an insulator, such as SOG and to be able to tune the gap-filling properties.

As it is possible to control the diameter of the wire, it is also possible to control the emission properties, as the diameter of the wire effects the surface/volume ratio which also effects the emission properties. Thus, being able to place nucleation spots that are large in diameter with little spacing in between, maximize the area of the substrate that is utilized and thus even the effective area/area of the substrate, which is an important factor in industrial production.

The substrate, or a part thereof, can for example be constituted by one of the group of glass, conductive plastic, conductive polymer, Silicon (Si), Silicon Carbide (SiC), Sapphire (Al2O3), Silicon Nitride, Poly(3,4-ethylene-dioxythiophene) (PEDOT), transparent conductive oxide family (TCO) such as p-SrCu2O2. That is, not only materials that may accept only high temperatures but also materials that do not accept high temperature can be selected as the substrate.

The electrically conductive layer is essentially flat. This leads to increased opportunities to control the physical properties, including electrical properties, such as conductivity, and reflectivity and transparency. Also, it is easier to have control over the thickness, and its physical consequences, when the layer is flat. The nominal thickness of the electrically conductive layer is more than 0.5 nanometers, and preferrably between 1 and 3 nanometers.

It is possible to select different types of electrically conductive layer, and as an alternative, the electrically conductive layer is a nucleation layer. However, the electrically conductive layer can also belong to the group of a metallic layer, an electrically conductive ceramic layer, and a transparent conductive oxide layer. If the electrically conductive layer is a metallic layer, the metallic layer can belong to the groups of a layer of a transition metal, a layer of a noble metal, a layer of a metal, and a layer of a metal alloy, where the layer of a noble metal is constituted by one from the group of Gold (Au), Platinum (Pt), Silver (Ag), Copper (Cu), Palladium (Pd), and Tantalum. In general, noble metals may also be referred to as coin metals and precious metals. The term noble metal includes metals that resist chemical action, does not corrode or tarnish on air or water, and is not easily attacked by acids. Similarly, if the electrically conductive layer is a transparent conductive oxide layer, the transparent conductive oxide layer can be an Indium Tin oxide (ITO) layer.

Furthermore, the electrically conductive layer is preferably formed using one of photolithography and/or e-beam lithography. E-beam lithography allows for a higher resolution and thus a better accuracy when forming the electrically conductive layer on the substrate.

In a preferred embodiment, the temperature interval is between 50 and 95 degrees Celsius. Having a slightly tighter temperature interval provides for the possibility to grow the nanorods in a more controlled environment, where also the use of a lower top temperature provides for the possibility to grow the nanorods on more delicate substrates, such as for example plastic.

In another preferred embodiment, the above described step of forming the electrically conductive layer comprises forming the electrically conductive layer on all surfaces of the substrate. Forming the electrically conductive layer on all of the surfaces provides for the possibility to grow nanorods on all sides of the substrate.

Preferably, the step of forming the electrically conductive layer is achieved by heterogeneous nucleation, but can also be achieved by dispersing colloidal particles related to the electrically conductive layer on the surface of the substrate. Other methods for forming the electrically conductive layer is possible, and within the scope of the present invention.

In an embodiment, the method according to the present invention further comprises at least one of the steps of controlling the size of at least one region of electrically conductive layer on the substrate, and/or controlling the position on the substrate. In the art, this is referred to as lithographic (pre)patterning. Controlling the size of position of nucleation layer for heterogeneous nucleation allows us to control the position and diameter of the subsequent growing nanorod. This can be done by periodic patterning of the substrate with the help of photolithography, which also allows for controlling of the spacing and diameter of the metal spots for nucleation that gives the possibility to control the spacing between the nanorods, and the diameter of nanorods. Since this process defines the exact nucleation area, it allows for controlling and influencing the active p-n junction area. This feature can give further insight into the problem of heat management and junction area, junction current density etc. Controlling these parameters is crucial for standardizing an LED-product at a later stage of technical development. For special applications where the resolution of photolithography is not sufficient, e-beam lithography could be employed, giving higher precision.

In an alternative embodiment, the preparation of the mixture comprises the step of adding at least one dopant substance to the mixture, and/or the step of adding an additional precursor to the mixture. The dopant substance is preferably selected from a group I elements, such as Li or K, or group V elements such as N, P, As etc. Primarily group one elements are easy to add to the solution in the form of salts as well as N, contained in a solution. Codoping methods are also possible, such as a group I and group V elements. This is primarily for growing p-type region of the nanowire, as both n- and pis needed for an LED. By introducing foreign dopant substances during the growth process, it is possible to modify the electronic properties of ZnO nanorods or parts thereof. Depending on the substance introduced, the effect can be either the increase in n-type carriers or an overcompensation of n-type conductivity that will result in p-type doping (by foreign atoms being incorporated into ZnO structure). Preferably, the relation between precursor, e.g. a zinc containing precursor, or even more specifically Zn(NO3)2 and the band gap modifier is 67%-99%:33-1%.

### Brief description of the drawings

These and other aspects of the present invention will now be described in more detail, with reference to the appended drawing showing currently preferred embodiments of the invention, in which:

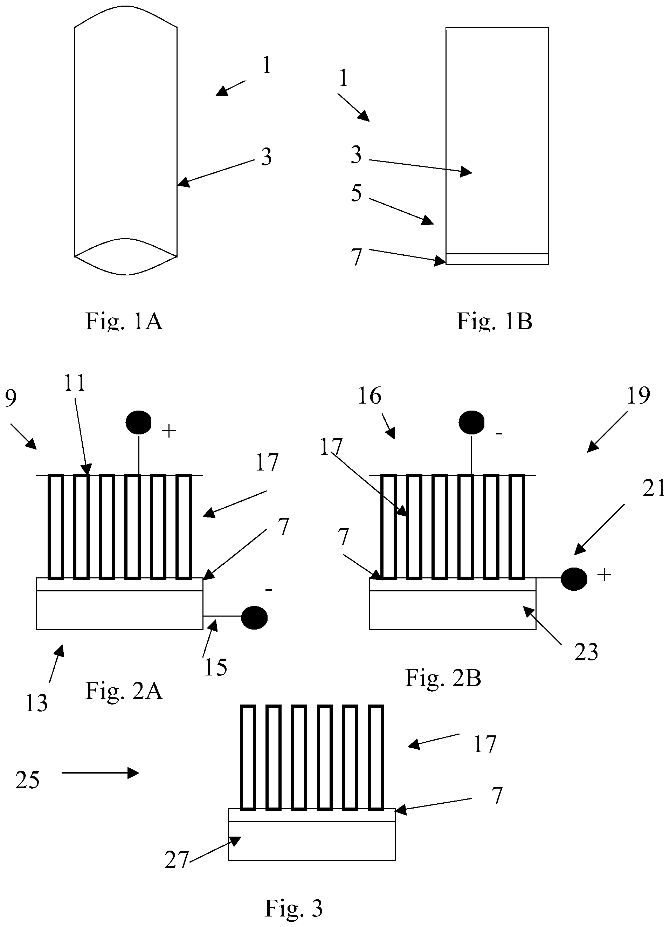

Figure 1 a illustrates an embodiment of a nanorod; and
Figure 1 b illustrates an embodiment of a nanorod from a side view that comprises an end presenting an electrically conductive layer;
Figures 2a and 2b illustrates different embodiments of nano contacts; and
Figure 3 illustrates an embodiment of a nano electric device.

### Detailed description of currently preferred embodiments

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiment are provided for thoroughness and completeness, and fully convey the scope of the invention to the skilled addressee. Like reference characters refer to like elements throughout.

Referring now to figure 1 a and 1 b, depicting a free standing nano rod 1. The nanorod 1 comprises an oblong Zinc oxide nano construct 3 and the oblong Zinc oxide nano construct 3 is, as grown, free standing. The electrically conductive layer 7 is a nucleation layer. A thin metal layer is deposited typically with methods such as sputtering or e-beam evaporation.

This layer presents a nominal thickness above 0.5 nanometers, and preferably between 1 and 3 nanometers. Furthermore, as an example, the electrically conductive layer 7 can belong to a group comprising, but not limited to, a metallic layer, namely a layer of Gold (Au) and other metals.

Alternatives to electrically conductive layers 7 include TCO, ITO and single walled carbon nanotubes (SWCNT). ITO - In2O3 doped with SnO2 (Indium Tin Oxide, usually combined by weight in 90%:10% ratio) is a preferred alternative to the electrically conductive nucleation layer. It provides a nano contact due to its high conductivity and good transparency at thicknesses up to 200nm. The properties of ITO are high conductivity combined with high transparency in the visible region that is useful in numerous applications. Alternatives to ITO may be selected from the group of TCOs (transparent conductive oxides), for instance Al or Ga doped ZnO (AZO and GZO). These materials can potentially offer properties such as lower resistivity, higher stability and better transparency than ITO. Another group of materials that can be used for such an electrode are single walled nanotubes (SWCNT). SWCNT can be used as transparent conductive electrodes with superior properties than ITO, with regards to the transparency and conductivity. These electrodes are low cost in production as they do not require standard high vacuum technologies employed for ITO deposition, such as e-beam evaporation or sputtering. This eliminates an expensive step in the production process. SWNT can be purchased in a solution and can be deposited onto the wafer by regular spin-coating or dip-coating. The work function of SWNT has been reported to be in the range of 4.5 to 5 eV, which is well-suited for making a nano contact to ZnO nanowires.

Turning now to figure 2a illustrating an embodiment of a nano contact 9. The nano contact 9 comprises two contact pads 11, 13 of opposite polarity (a top contact and a bottom contact), a substrate 15 and nano rods 17 electrically connecting the two contact pads 9, 11. The substrate 15 constitutes the bottom contact.

In figure 2b, an alternative embodiment of a nano contact 16 is given. The nano contact 16 comprises two contact pads 19, 21 of opposite polarity (a top contact and a bottom contact), a substrate 23 and nano rods 17 electrically connecting the two contact pads 19, 21. The substrate 23 is an isolating substrate 23. The electrically conductive layer 7 presents a nominal thickness between 2 and 200 nanometers. The work function of the electrically conductive layer 7 should be considered with respect to the decreasing the Schottky barrier between the metal and semiconductor in order to give a good ohmic contact. Even alloys of different metals can be used in this case. The case with work function alignment is different depending if ZnO nanowires grown are going to be p- or n-type. The thickness of the electrically conductive layer will have an effect on transparency of the device.

In figure 3, an embodiment of a nano electric device 25 is given. It comprises a substrate 27 at a surface of which a plurality of nanorods 17 has been grown. The substrate 27 is constituted by a conductive plastic.

Typical dimensions, such as length, of nanorods developed with the low temperature growth according to the present invention are dependent on growth time. The experimental approximate growth time is one micrometer per hour. For further LED-fabrication reasons, nanorods of the order of approximately one micrometer in length are optimal. The diameters of nanorods that have been achieved are typically 100 nanometers. Larger diameters such as 500 to 1000 nanometers together with narrow spacing between the nanowires that gives the advantage of covering a larger portion surface area. However producing a critically small diameter gives the advantage of quantum confinement and light extraction. Using the inventive method it is possible to obtain an aspect ratio as low as 1.

As mentioned above, it is possible to insert metals and materials to modify the band-gap. MgxZn1-xO and ZnyCd1-yO can be formed by adding salts to the solution containing Mg2+ and Cd2+ ions together with Zn containing salt into the growth solution. In the resulting growth, Mg2+ or Cd2+ ions are incorporated into the crystal lattice structures in Zn place. The band gap and lattice constant may be changed linearly depending on the composition of the alloy. The band-gap can thus be tuned engineered between 3.0 (y=0.07) and 4.0 eV (x=0.33).

When having provided the substrate with an effective nucleation layer, the growth of alloys takes place by introducing different compositions of Zn containing salts together with either Mg or Cd salts. For example, the method according to the present invention could include a timed, periodic variance of concentration of precursors (Zn, Cd and Mg) in the wet chemical solution providing growth of different compositions of alloys and ultimately confinement characteristics of the semiconductor structure.

A sample of growing CdyZn1-yO structure could be growth of an alloy with a smaller band-gap, on a p-type substrate with a larger bad-gap that that of the alloy, providing an enhanced hole injection from the p-type layer into the alloy.

Furthermore, a highly efficient light emitting device can be based on MgxZn1-xO (that has the band-gap energy between 3.37 and 4.02 at room temperature) alloy in the form of nanorods. MgxZn1-xO may appropriately be used in the cladding layers between which the active layer is sandwiched. The active layer can consist of a multiple of quantum wells or a double heterostructure. The active region may contain any alloy composition of either MgxZn1-xO, ZnO or CdxZn1-xO with a smaller band-gap energy than then cladding layer, providing enhanced light emission characteristic and carrier confinement within the active layer. The nanorods containing these alloys are grown in a wet chemical bath.

The active region, which can be a single well or repeated wells is obtained with the combinations of ZnO alloys mentioned above. Preferably, the ZnO nanowire is grown by low temperature method or any other method, and the active region can be grown with the low temperature method for the advantages that are mentioned above.

As an alternative, the active region can be placed directly on a thin film or substrate of other material. As these materials will have a different position of the band structure and band gap, growing alloys of ZnO (MgZnO, CdMgO and MnZnO) allows to tune the band structure between the substrate or thin film material underneath and the nanowire, allowing the junction to function efficiently and to obtain the desired light emission properties. These would include, for instance that, the case where it would be preferred to arrange for emission to take place inside the ZnO nanowire, and not in the substrate. The band gap could be tuned so that carriers are injected into the nanowire and not from the nanowire into the substrate.

Also, dopants can be included in of the growth process. By introducing foreign dopant substances during the growth process, it is possible to modify the electronic properties of ZnO nanorods or parts thereof. Depending on the substance introduced, the effect can be either the increase in n-type carriers or an overcompensation of n-type conductivity that will result in p-type doping (by foreign atoms being incorporated into ZnO structure).

As grown ZnO is a natural n-type semiconductor with doping level of the order of 1017 to 1018 n-type carriers/cm3. However, larger doping concentration and conduction may be desired. An increase in n-type doping can be attained by adding group III elements that will substitute Zn positions, Al, Ga and In. For compensating n-type conductivity and attaining p-type any element or combination of elements of Li, Na, Cu, P As could be used (group I will substitute Zn positions and group III will substitute O positions). Also, Cu can function as a p-type dopant due to formation of CuO that is a p-type semiconductor in the non-doped status. Al, Ga and In, co-doped with N could also result as a source of p-type conductivity.

The skilled addressee realizes that the present invention by no means is limited to the preferred embodiments described above. On the contrary, many modifications and variations are possible within the scope of the appended claims. For example, apart from the building quantum confinement structures of MgZnO/ZnO and CdZnO/ZnO inside the nanowire, the method according to the present invention is extremely useful for growing the nanowires on top of p-type substrates and films as described in EP1791186. The structure described in EP1791186 utilizes the use of p-type films and substrates for injection of holes in ZnO nanowires. To optimize the matching of the band structures between the p-type substrates or p-type film and ZnO nanowires, sometimes the bandgap of ZnO has to be increased (as in MgZnO) or decreased (as in CdZnO). This can for example make p-n junction more efficient, and/or also increase the hole injection into ZnO nanowires from the p-type substrate or film and decrease the electron injection into p-type film or substrate from ZnO nanowires.

Thus, from a general perspective the method according to the present invention does not only allow to make a confinement region inside the ZnO nanowire when both p-type ZnO and n-type ZnO is employed, but also to fabricate efficient heterojunction LEDs by altering the band-gap of ZnO and matching it to p-type substrates and films.

Furthermore, non-limiting application areas of the present invention include LED, LD (laser diode), solar cells, transistors etc. The ZnO nanorods could also be utilised as transparent electrodes. Single nanorods grown between two contact pads could also be utilised in a number of future sensitive nanotechnology applications.

## Claims

1. Method for manufacturing of a nanorod, comprising the steps of:
- providing a substrate;
- forming an essentially flat electrically conductive layer on a surface of the substrate, the conductive layer having a thickness in the range of more than 0.5 to 3 nm, thereby forming an assembly;
- preparing a mixture comprising a Zinc containing precursor and tetramine in water;
- adding a salt comprising at least one of Mg2+ and Cd2+ to the mixture;
- heat treating the assembly in the mixture in a temperature interval between 30 and 120 degrees Celsius; and
- drying the assembly.

2. Method according to claim 1, wherein the temperature interval is between 50 and 95 degrees Celsius.

3. Method according to any of claims 1 or 2, wherein the step of forming the electrically conductive layer comprises forming the electrically conductive layer on all surfaces of the substrate.

4. Method according to any one of the preceding claims, wherein the step of forming the electrically conductive layer is achieved by heterogeneous nucleation.

5. Method according to any of claims 1 - 3, wherein the step of forming the electrically conductive layer is achieved by dispersing colloidal particles related to the electrically conductive layer on the surface of the substrate.

6. Method according to any one of the preceding claims, wherein the step of preparing the mixture comprises the step of adding at least one dopant substance to the mixture.

7. Method according to any one of the preceding claims, wherein the step of preparing the mixture comprises the step of adding an additional precursor to the mixture.

8. Method according to claim 8, wherein the relation between the precursor and the at least one additional precursor is 67-99%:33-1%.

9. Method according to any one of the preceding claims, further comprising at least one of the steps of:
- controlling the size of at least one region of electrically conductive layer on the substrate;
- controlling the position on the substrate.

## Patentansprüche

1. Verfahren zur Herstellung eines Nanostäbchens, wobei es die folgenden Schritte umfasst:
- Bereitstellen eines Substrats;
- Bilden einer im Wesentlichen flachen elektrisch leitfähigen Schicht auf einer Oberfläche des Substrats, wobei die leitfähige Schicht eine Dicke in der Größenordnung von mehr als 0,5 bis 3 nm hat, um auf diese Weise eine Anordnung zu bilden;
- Herstellen einer Mischung, die eine zinkhaltige Vorläufersubstanz und Tetramin in Wasser umfasst;
- Hinzufügen eines Salzes, das mindestens eines von Mg²⁺ und Cd²⁺ umfasst, zu der Mischung;
- Wärmebehandeln der Anordnung in der Mischung in einem Temperaturintervall zwischen 30 und 120 Grad Celsius; und
- Trocknen der Anordnung.

2. Verfahren nach Anspruch 1, wobei das Temperaturintervall zwischen 50 und 95 Grad Celsius beträgt.

3. Verfahren nach einem beliebigen der Ansprüche 1 oder 2, wobei der Schritt des Bildens der elektrisch leitfähigen Schicht das Bilden der elektrisch leitfähigen Schicht auf sämtlichen Oberflächen des Substrats umfasst.

4. Verfahren nach einem beliebigen der vorhergehenden Ansprüche, wobei der Schritt des Bildens der elektrisch leitfähigen Schicht mittels heterogener Keimbildung erfolgt.

5. Verfahren nach einem beliebigen der Ansprüche 1 - 3, wobei der Schritt des Bildens der elektrisch leitfähigen Schicht erfolgt, indem kolloidale Partikel, die mit der elektrisch leitfähigen Schicht in Zusammenhang stehen, auf der Oberfläche des Substrats dispergiert werden.

6. Verfahren nach einem beliebigen der vorhergehenden Ansprüche, wobei der Schritt des Herstellens der Mischung den Schritt des Hinzufügens mindestens einer Dotiersubstanz zu der Mischung umfasst.

7. Verfahren nach einem beliebigen der vorhergehenden Ansprüche, wobei der Schritt des Herstellens der Mischung den Schritt des Hinzufügens einer zusätzlichen Vorläufersubstanz zu der Mischung umfasst.

8. Verfahren nach Anspruch 8, wobei das Verhältnis zwischen der Vorläufersubstanz und der mindestens einen zusätzlichen Vorläufersubstanz 67 - 99 % : 33 - 1 % beträgt.

9. Verfahren nach einem beliebigen der vorhergehenden Ansprüche, wobei es weiterhin mindestens einen der folgenden Schritte umfasst:
- Steuern der Größe mindestens einer Region der elektrisch leitfähigen Schicht auf dem Substrat;
- Steuern der Position auf dem Substrat.

## Revendications

1. Procédé de fabrication d'une nanotige, comprenant les étapes consistant à :
- fournir un substrat ;
- former une couche conductrice d'électricité essentiellement plate sur une surface du substrat, la surface conductrice possédant une épaisseur dans la gamme comprise entre plus de 0,5 et 3 nm, formant ainsi un assemblage ;
- préparer un mélange comprenant un précurseur contenant du zinc et de la tétramine dans de l'eau ;
- ajouter un sel comprenant au moins un de Mg²⁺ et de Cd²⁺ au mélange ;
- traiter par chauffage l'assemblage dans le mélange dans un intervalle de température compris entre 30 et 120 °C ; et
- sécher l'assemblage.

2. Procédé selon la revendication 1, dans lequel l'intervalle de température est compris entre 50 et 95 degrés Celsius.

3. Procédé selon la revendication 1 ou 2, dans lequel l'étape consistant à former la couche conductrice d'électricité consiste à former la couche conductrice d'électricité sur toutes les surfaces du substrat.

4. Procédé selon l'une quelconque des revendications précédentes, dans lequel l'étape consistant à former la couche conductrice d'électricité est effectuée par une nucléation hétérogène.

5. Procédé selon l'une quelconque des revendications 1 - 3, dans lequel l'étape consistant à former la couche conductrice d'électricité est effectuée en dispersant des particules colloïdales liées à la couche conductrice d'électricité sur la surface du substrat.

6. Procédé selon l'une quelconque des étapes précédentes, dans lequel l'étape consistant à préparer le mélange comprend l'étape consistant à ajouter au moins une substance dopante au mélange.

7. Procédé selon l'une quelconque des revendications précédentes, dans lequel l'étape consistant à préparer le mélange comprend l'étape consistant à ajouter un précurseur supplémentaire au mélange.

8. Procédé selon la revendication 8, dans lequel la relation entre le précurseur et l'au moins un précurseur supplémentaire est de 67-99 % : 33-1 %.

9. Procédé selon l'une quelconque des revendications précédentes, comprenant en outre au moins une des étapes consistant à :
- contrôler la taille d'au moins une région de la couche conductrice d'électricité sur le substrat ;
- contrôler la position sur le substrat.
